Europäisches Patentamt

European Patent Office

Office européen des brevets

(19)

(11) Veröffentlichungsnummer: **0 036 417**
**B1**

(12) **EUROPÄISCHE PATENTSCHRIFT**

(45) Veröffentlichungstag der Patentschrift:
**19.10.83**

(21) Anmeldenummer: **80901785.8**

(22) Anmeldetag: **26.09.80**

(86) Internationale Anmeldenummer:
**PCT/AT 80/00030**

(87) Internationale Veröffentlichungsnummer:
**WO 81/01092 (16.04.81 Gazette 81/9)**

(51) Int. Cl.³: **H 05 K 5/00, H 05 K 7/02**

(54) **RECHNERGESTEUERTES SCHALTGERÄT.**

(30) Priorität: **02.10.79 AT 6438/79**

(43) Veröffentlichungstag der Anmeldung:
**30.09.81 Patentblatt 81/39**

(45) Bekanntmachung des Hinweises auf die Patenterteilung:
**19.10.83 Patentblatt 83/42**

(84) Benannte Vertragsstaaten:
**CH DE FR GB LI NL SE**

(56) Entgegenhaltungen:
**DE-A-2 310 103**
**DE-A-2 359 452**
**DE-A-2 736 546**

(73) Patentinhaber: **NAIMER, Hubert Laurenz,**
**Schumanngasse 33-37, A-1181 Wien (AT)**

(72) Erfinder: **NAIMER, Hubert Laurenz,**
**Schumanngasse 33-37, A-1181 Wien (AT)**

(74) Vertreter: **Kliment, Peter, Dipl.-Ing.Mag.-Iur.,**
**Singerstrasse 8, A-1010 Wien (AT)**

BUNDESDRUCKEREI BERLIN

Rechnergesteuertes Schaltgerät

Die Erfindung bezieht sich auf ein rechnergesteuertes Schaltgerät zur Steuerung von Leistungsschaltelementen, wie Schützen, Motorschutzschaltern od. dgl., zur Steuerung von Geräten oder Anlagen bei dem der Rechner über Analog-Digitalwandler mit mindestens einem die Stromaufnahme des zu überwachenden Gerätes, z. B. eines Motors, Trafos od. dgl. überwachenden Fühler verbunden ist und nach einem bestimmten Modell Kenndaten errechnet und bei Über- und bzw. Unterschreiten bestimmter vorgegebener Werte, Schaltbefehle abgibt.

Ein derartiges Schaltgerät ist durch die DE-AS 2 310 103 bekanntgeworden.

Aus der DE-A-2 359 452 ist ein Schaltgerät mit die Stromaufnahme eines zu überwachenden Geräts überwachenden Fühlern bekannt, bei dem die Fühler auf das Magnetfeld der zum zu überwachenden Gerät führenden Leitung bzw. Leitungen ansprechen und mit je einer Durchführung versehen sind, die mit im Gehäuse vorgesehenen Durchführungen fluchten.

Ziel der Erfindung ist es nun, ein Schaltgerät der eingangs erwähnten Art vorzuschlagen, das einfach zu montieren ist und sich durch einen einfachen mechanischen Aufbau auszeichnet.

Erfindungsgemäß wird dies dadurch erreicht, daß der bzw. die auf das Magnetfeld der zum zu überwachenden Gerät führenden Leitung bzw. Leitungen ansprechenden Fühler auf einer Platine angeordnet und mit je einer Durchführung versehen sind, welche mit im Gehäuse vorgesehenen Durchbrüchen fluchten, und daß das Gerät zwei Platinen umfaßt, die miteinander elektrisch, durch lösbare Steckverbindungen verbunden sind, und von denen die eine mit Anschlußklemmen und dem vom Rechner gesteuerten Schaltelement sowie gegebenenfalls einem Netzgerät und bzw. oder einer Spannungsquelle und die andere mit den Fühlern und dem Rechner samt den Analog-Digitalwandlern und den Einstellelementen bestückt ist.

Durch den kompakten Aufbau des Schaltgerätes und die Anordnung von Durchführungen für die zum zu überwachenden Gerät führenden Leitungen ist eine sehr einfache Montage des Gerätes möglich. Praktisch müssen lediglich die Leitungen vom zu schützenden bzw. zu steuernden Gerät oder vom Leistungsschaltelement abgeklemmt und durch das Schaltgerät hindurchgeführt und wieder angeklemmt werden, desgleichen die zum Leistungsschaltelement führenden Steuerleitungen.

Im Falle der Verwendung von Hallgeneratoren als Fühler ergibt sich in Verbindung mit dem Rechner der Vorteil, daß das Steuergerät in einer großen Bandbreite hinsichtlich der Größe der zu überwachenden Ströme einsetzbar ist. So ist durch eine solche Kombination ohne besonderen Aufwand z. B. ein Stromeinstellbereich bei Motorschutzschaltern von 1 : 10 erreichbar.

Ein besonders einfacher mechanischer Aufbau des erfindungsgemäßen Schaltgerätes ergibt sich, wenn die Baueinheit im wesentlichen zwei Platinen umfaßt, die miteinander elektrisch, durch lösbare Steckverbindungen verbunden sind, und von denen einer mit den Anschlußklemmen und dem vom Rechner gesteuerten Schaltelement sowie gegebenenfalls einem Netzgerät und bzw. oder einer Spannungsquelle und der andere mit den Fühler und dem Rechner samt den Analog-Digitalwandlern und den Einstellelementen bestückt ist. Damit wird die Auslegung der Platinen wesentlich erleichtert und es wird gleichzeitig eine Trennung der mit kleineren Spannungen arbeitenden elektronischen Bauteile von dem mit zumeist höheren Spannungen arbeitenden Bauteilen, wie ein Netzgerät oder das vom Rechner gesteuerte Schaltelement, letzteres selbstverständlich nur im Hinblick auf seinen Ausgangskreis, erreicht. Durch die Unterbringung der lediglich mit niedriger Spannung, z. B. 5 V betriebene elektronische Bauteile und der eine höhere Spannung, z. B. 220 V führenden Bauteile wie Netzgerät und Schaltelement auf getrennten Platinen werden auch Störungsquellen vermieden.

In bezug auf die Herstellung bzw. eines möglichst geringen Aufwandes beim Zusammenbau des Schaltgerätes ist es besonders vorteilhaft, wenn zur mechanischen Verbindung der beiden Platinen ein Gehäuse vorgesehen ist, welches aus zwei Hälften besteht, welches Durchbrüche bzw. Ausnehmungen zur Aufnahme der Klemmen und der Einstellorgane sowie den Durchführungen entsprechende Durchbrüche aufweisen und die — vorzugsweise durch eine Schnappverbindung — miteinander verbindbar sind, und die in ihren inneren Flächen, Vorsprünge aufweisen, die mit ihren einander zugekehrten Flächen im zusammengebauten Zustand des Gehäuses auf die Platinen drücken, wobei zweckmäßigerweise die beiden Platinen miteinander zugekehrten Leiterseiten miteinander verbunden sind.

Die Erfindung wird nun anhand der Zeichnungen näher erläutert. Dabei zeigen

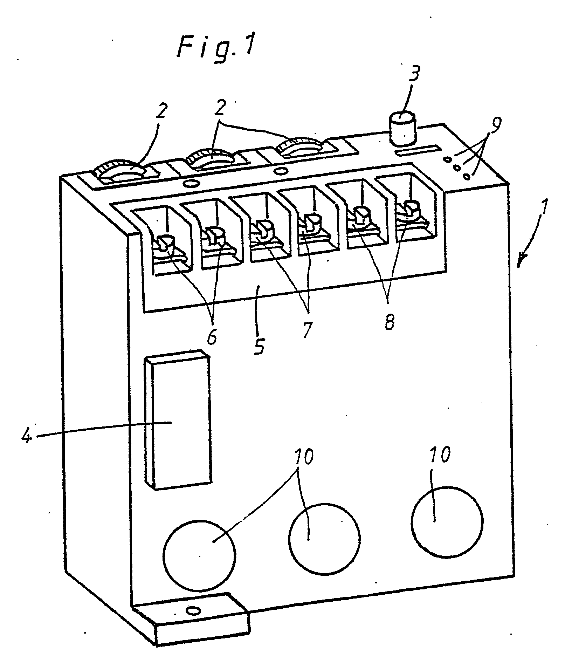

Fig. 1 und 2 verschiedene Ausführungsformen eines erfindungsgemäßen Schaltgerätes,

Fig. 3 eine Explosionsdarstellung des Schaltgerätes nach Fig. 1 und

Fig. 4 und 5 Schaltpläne für den Einsatz der Schaltgeräte gemäß Fig. 1 und 2.

Das als Baueinheit aufgebaute Schaltgerät 1 bzw. 1' weist Einstellorgane 2 zur Einstellung bzw. Eingabe von Kenndaten z. B. des Nennstromes des zu überwachenden Motors in den Rechner, sowie weitere, nicht dargestellte Einstellorgane für die Einstellung weiterer Kenndaten, z. B. über Anlaufbedingungen, Raumtemperaturverhältnisse od. dgl. auf. Weiters ist eine Rückstelltaste 3 zur Rückstellung des Schaltelementes 4 vorgesehen, falls dieses im Störungsfalle angesprochen hat. Der Klemmenblock 5 ist mit Klemmen 6 für den Anschluß der Spule des zu steuernden Leistungsschaltelementes, Klemmen 7 für eine Störungsmeldung und Klemmen 8 für eine Fernbetätigung der Rückstellung des Schaltelementes 4 bestückt. Außerdem sind noch Leuchtdioden 9 zur Anzeige von Störungen vorgesehen. Für die zum zu überwachenden Gerät führenden Leitungen sind die Durchbrüche 10 vorgesehen.

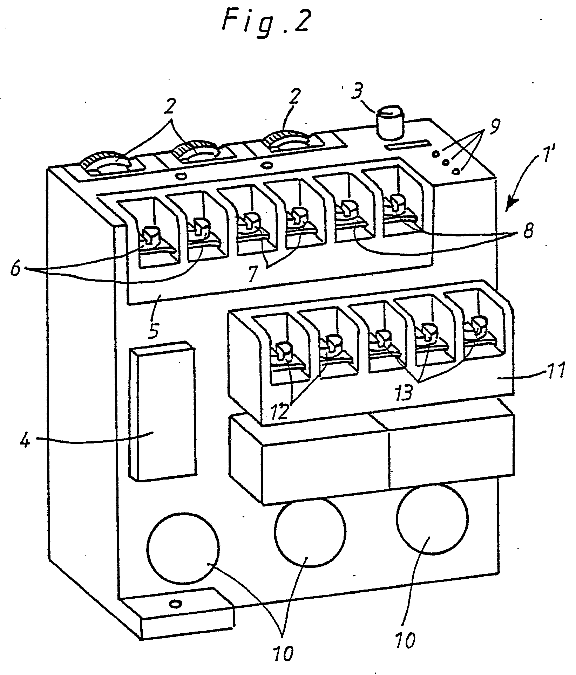

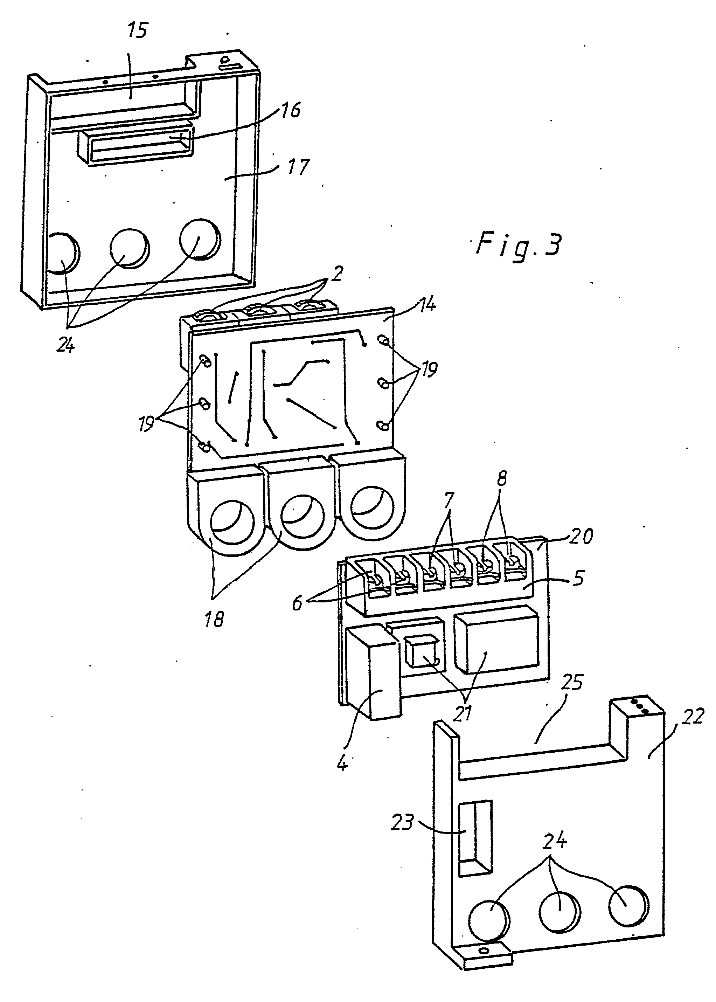

Die Ausführungsformen gemäß Fig. 2, die zusätzlich für die Steuerung von Stern-Dreieck-Schützen vorgesehen ist, weist überdies noch einen weiteren Klemmenblock 11 mit Klemmen 12 zum Anschluß eines Thermofühlers des Motors und Klemmen 13 für den Anschluß der Spulen der Stern-Dreieck-Schütze auf. Der Aufbau des Schaltgerätes 1 ist aus Fig. 3 ersichtlich.

Auf einer Printplatte 14 sind die Einstellorgane 2, sowie weitere nicht dargestellte Einstellorgane, für welche die Aussparungen 15 bzw. 16 in der Gehäusehälfte 17 vorgesehen sind, angeordnet. Weiters trägt die Platine 14 die auf das Magnetfeld der zum zu schützenden Gerät führenden Leitungen ansprechenden Fühler 18, welche z. B. durch in die Durchführung der Leitungen ermöglichenden Kunststoffblöcken eingegossene Hall-Generatoren oder auch durch Ringkernwandler gebildet sein können, den nicht dargestellten durch einen Mikroprozessor gebildeten Rechner samt den zugehörigen Analog-Digitalwandlern, die Rückstellschalter für das Schaltelement 4 und die Leuchtdioden 9 zur Störungsmeldung samt deren Ansteuerschaltung. Auf der Platine 14 sind weiters Buchsen 19 angeordnet, mit deren Hilfe die elektrische Verbindung zwischen den Platinen 14 und 20 herstellbar ist.

Die Platine 20 ist im wesentlichen mit dem Klemmenblock 5, dem Schaltelement 4 und dem Netzgerät 21, sowie an seiner Rückseite mit in die Buchsen 19 passenden Stiften bestückt, welche die elektrische Verbindung der beiden Platinen herstellen. Die Platine 20 entspricht in seinen Abmessungen dem von den Fühlern 18 freien Abschnitt des Prints 14. Mechanisch zusammengehalten werden die beiden Platinen außer durch den Reibungsschluß der Stifte in den Buchsen 19 durch die beiden Hälften 17 und 22 des Gehäuses, welche beiden Durchbrüche 15, 16, 23, 24 bzw. eine Ausnehmung 25 aufweisen und mittels einer nicht dargestellten Schnappverbindung verbindbar sind. Die Durchbrüche 15, 26, 23 und 24 sind von gegen die Innenseite gerichteten Wänden bzw. Ansätzen begrenzt, deren einander zugekehrte Stirnflächen einen Spalt definieren, in dem die beiden Platinen 14, 20 bei miteinander verbundenen Gehäusehälften 17, 22 eingeklemmt sind.

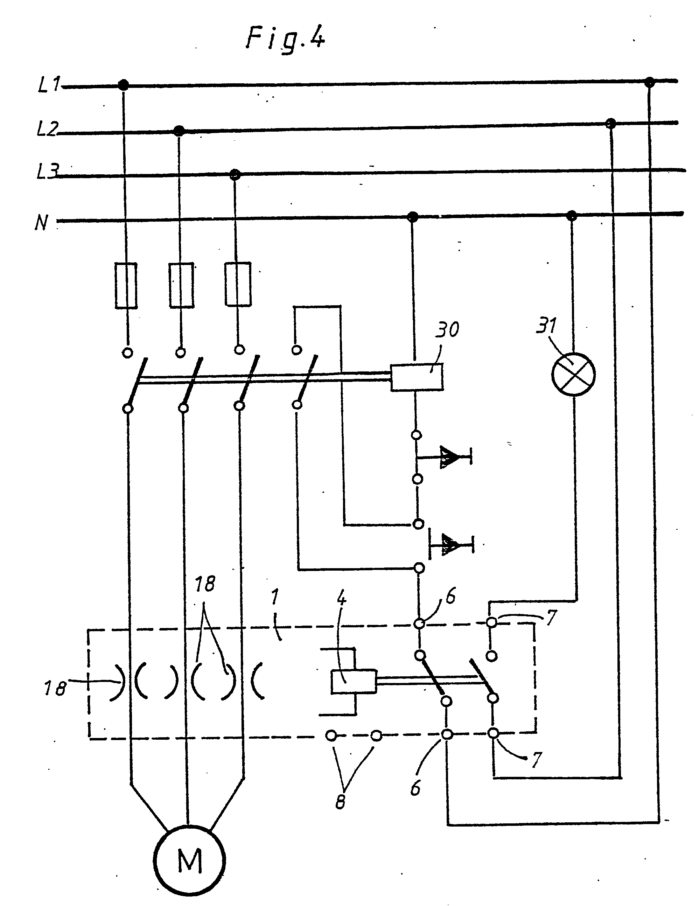

Fig. 4 zeigt einen Schaltplan für den Einsatz eines Schaltgerätes nach der Erfindung, wobei das Schaltgerät 1 den Schütz 30 für das Schalten des Motors M und eine Signallampe 31 steuert.

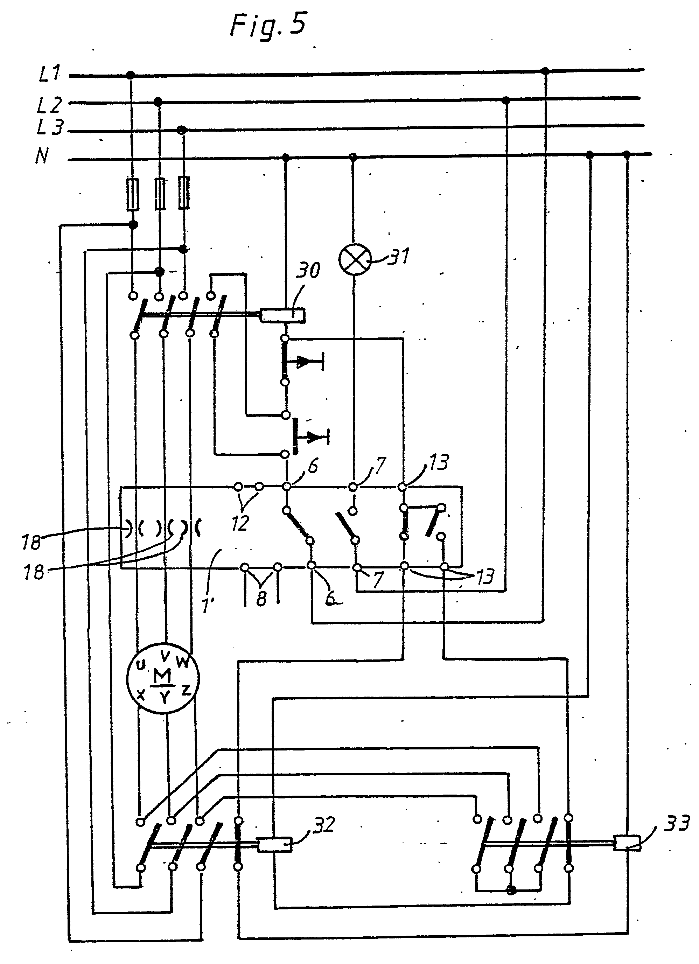

Gemäß dem Schaltplan nach Fig. 5 ist das Schaltgerät 1' zusätzlich zur Steuerung der Stern-Dreieck-Schütze 32, 33 vorgesehen, wobei das Sternschütz bei Unterschreiten eines bestimmten Stromwertes z. B. 90% des Nennstromes des Motors ausgeschaltet wird, das Dreieckschütz aber erst nach Erlöschen der Schaltlichtbögen des Sternschützes bzw. unmittelbar nachdem die Motorströme den Wert 0 erreicht haben, eingeschaltet wird, wobei der Stromwert durch den Rechner anhand der eingegebenen Daten und der ermittelten Betriebsparameter, wie z. B. Dauer- und Intensität sowie Standzeit vor dem zu überwachenden Anlauf ermittelt wird.

Die Stromversorgung des Schaltgerätes 1 bzw. 1' kann zweckmäßigerweise über die mit den Leitern L1 bzw. L2 verbundenen Klemmen 6 und 7 erfolgen, wodurch auch eine Energieversorgung des Rechners während des Stillstandes des Motors M und auch eine Selbsthaltung des Schaltelementes 4, welches auch durch einen Halbleiterbauteil gebildet sein kann, ermöglicht. Weiters kann aber für die Stromversorgung des Schaltgerätes 1 bzw. 1' auch eine Batterie vorgesehen werden, so daß die Ermittlung der Betriebsparameter auch bei einem Netzausfall nicht beeinträchtigt ist. Diese Batterie kann auch über das Netzgerät ständig geladen werden.

## Patentansprüche

1. Rechnergesteuertes Schaltgerät (1, 1') zur Steuerung von Leistungsschaltelementen, wie Schützen, Motorschutzschaltern od. dgl. zur Steuerung von Geräten oder Anlagen bei dem der Rechner über Analog-Digitalwandler mit mindestens einem die Stromaufnahme des zu überwachenden Gerätes, z. B. eines Motors, Trafos od. dgl. überwachenden Fühler (18) verbunden ist und nach einem bestimmten Modell Kenndaten errechnet und bei Über- und bzw. oder Unterschreiten bestimmter vorgegebener Werte Schaltbefehle abgibt, dadurch gekennzeichnet, daß der bzw. die auf das Magnetfeld der zum zu überwachenden Gerät führenden Leitung bzw. Leitungen ansprechenden Fühler (18) auf einer Platine (14) angeordnet und mit je einer Durchführung versehen sind, welche mit im Gehäuse vorgesehenen Durchbrüchen (10, 24) fluchten, und daß das Gerät (1, 1') zwei Platinen (14, 20) umfaßt, die miteinander elektrisch, durch lösbare Steckverbindungen (19) verbunden sind, und von denen die eine mit Anschlußklemmen (6, 7, 8) und dem vom Rechner gesteuerten Schaltelement (4) sowie gegebenenfalls einem Netzgerät (21) und bzw. oder einer Spannungsquelle und die andere (14) mit den Fühlern (18) und dem Rechner samt den Analog-Digitalwandlern und den Einstellelementen (2) bestückt ist.

2. Schaltgerät nach Anspruch 1, mit einem aus zwei Hälften bestehenden Gehäuse, deren Hälften vorzugsweise durch eine Schnappverbindung miteinander verbindbar sind, dadurch gekennzeichnet, daß die beiden Hälften (17, 22) in ihren inneren Flächen, Vorsprünge aufweisen, die mit ihren einander zugekehrten Flächen im zusammengebauten Zustand des Gebäudes auf die Platinen (14, 20) drücken um diese zusammenzuhalten.

3. Schaltgerät nach Anspruch 1 oder 2, dadurch gekennzeichnet, daß die beiden Platinen (14, 20) miteinander zugekehrten Leiterseiten miteinander verbunden sind.

## Claims

1. Computer-controlled switching apparatus (1, 1') for the control of power switching elements, such as relays, engineprotecting cut-outs or the like, for controlling apparatus or installations in which the computer is connected via an analog-digital converter with at least one sensor (18) which monitors the current consumption of the apparatus to be monitored, e.g. of a motor, transformer or the like and calculates data according to a particular model and delivers switching instructions when particular predetermined values are exceeded or fallen short of, characterised in that the sensor or sensors (18) corresponding to the conductor or conductors leading to the magnetic field of the apparatus to be monitored is or are arranged on a plate (14) and is or are each provided with an opening which is in alignment with an opening (10, 24) provided in the housing, and that the apparatus (1, 1') comprises two plates (14, 20) which are electrically interconnected by disengageable plug-in connectors (19) and one of which is provided with connecting terminals (6, 7, 8) and with the switching elements (4) controlled by the computer as well as with, if necessary, a power supply unit (21) and/or a voltage source and the other (14) with the sensor (18) and the computer together with the analog-digital converters and the adjusting elements (2).

2. Switching apparatus according to claim 1, with a housing composed of two halves, the halves of which may advantageously be connected together by a spring fastening, characterised in that the two halves (17, 22) have projections on their inner surfaces which, in the assembled condition of the housing, press against the plates (14, 20) and hold them together by means of their mutually confronting surfaces.

3. Switching apparatus according to claim 1 or 2, characterised in that the two plates (14, 20) are connected together by means of their mutually confronting conductor-carrying sides.

## Revendications

1. Appareil de commutation (1, 1') contrôlé par ordinateur pour commander des éléments de commutation de puissance, tels que des relais, des dijoncteurs de protection de moteur ou similaires, pour commander des appareils ou des installations où le calculateur est relié par des convertisseurs analogiques-digitaux avec au moins un détecteur (18) surveillant l'intensité du courant de l'appareil à surveiller, par exemple un moteur, un transformateur ou similaire, et calcule des valeurs caractéristiques selon un modèle déterminé, et délivre des ordres de commutation si certaines valeurs prédéterminées sont dépassées dans le sens supérieur ou inférieur, caractérisé en ce que le ou les détecteurs (18) sensibles au champ magnétique de la (resp. des) ligne(s) menant à l'appareil à surveiller sont disposés sur une platine (14), sont munis chacun d'un passage qui est aligné avec des ouvertures (10, 24) prévues dans le boitier, et en ce que l'appareil comprend deux platines (14, 20) qui sont liées électriquement entre elles par des liaisons amovibles à fiches (19), l'une étant équipée de bornes de connexion (6, 7, 8) et de l'élément de commutation (4) contrôlé par le calculateur ainsi qu'éventuellement d'une unité d'alimentation (21) et/ou d'une source de tension, et l'autre est équipée des détecteurs (18) et du calculateur avec les convertisseurs analogiques-digitaux et les éléments de réglage (2).

2. Appareil de commutation selon la revendication 1, comportant un boitier formé de deux moitiés qui peuvent être liées entre elles de préférence par une liaison à déclic, caractérisé en ce que les deux moitiés (17, 22) présentent des saillies sur leurs faces internes, qui exercent une pression, par leurs faces tournées l'une vers l'autre dans l'état assemblé du boitier, sur les platines (14, 20) pour maintenir celles-ci réunies.

3. Appareil de commutation selon la revendication 1 ou 2, caractérisé en ce que les deux platines (14, 20) sont reliées entre elles par leurs côtés conducteurs tournés l'un vers l'autre.

*Fig.1*

# Fig.2

Fig.3

# Fig.4

# Fig. 5